(19) Europäisches Patentamt
European Patent Office
Office européen des brevets

(11) **EP 2 771 901 B1**

(12) **EUROPÄISCHE PATENTSCHRIFT**

(45) Veröffentlichungstag und Bekanntmachung des Hinweises auf die Patenterteilung:
**12.12.2018  Patentblatt 2018/50**

(21) Anmeldenummer: **12784435.5**

(22) Anmeldetag: **08.10.2012**

(51) Int Cl.:
*C23C 14/35* (2006.01)　　*H01J 37/34* (2006.01)
*C23C 14/34* (2006.01)

(86) Internationale Anmeldenummer:
**PCT/EP2012/004203**

(87) Internationale Veröffentlichungsnummer:
**WO 2013/060415 (02.05.2013 Gazette 2013/18)**

(54) **VERFAHREN ZUR BEREITSTELLUNG SEQUENZIELLER LEISTUNGSPULSE**

METHOD FOR SUPPLYING SEQUENTIAL POWER IMPULSES

PROCÉDÉ PERMETTANT DE FOURNIR DES IMPULSIONS DE PUISSANCE SÉQUENTIELLES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **28.10.2011  DE 102011117177**

(43) Veröffentlichungstag der Anmeldung:
**03.09.2014  Patentblatt 2014/36**

(73) Patentinhaber: **Oerlikon Surface Solutions AG, Pfäffikon**
**8808 Pfäffikon (CH)**

(72) Erfinder:
• **KRASSNITZER, Siegfried**
**A-Feldkirch (AT)**
• **LENDI, Daniel**
**CH-9472 Grabs (CH)**
• **LECHTHALER, Markus**
**A-6800 Feldkirch (AT)**

(74) Vertreter: **Kempkens, Anke**
**Hofgraben 486**
**86899 Landsberg (DE)**

(56) Entgegenhaltungen:
**WO-A1-2012/143087　　WO-A2-2008/071732
WO-A2-2009/132822　　DE-A1-102006 017 382
DE-U1-202010 001 497**

## Beschreibung

Die vorliegende Erfindung bezieht sich auf ein Verfahren zur Erzeugung von Leistungspulsen.

Solche Leistungspulse werden beispielsweise im Rahmen der HIPIMS-Technologie benötigt. HIPIMS steht für High Power Impulse Magnetron Sputtering. Dabei handelt es sich um ein Vakuumbeschichtungsverfahren bei dem mittels sehr hoher Entladungsströme Material von einer Kathode zerstäubt wird, wodurch garantiert ist, dass das zerstäubte Material hochgradig positiv ionisiert wird. Wird gleichzeitig an die zu beschichtenden Substrate eine negative Spannung angelegt, so hat dies zur Folge, dass die durch die Zerstäubung entstandenen positiven Ionen in Richtung Substrate beschleunigt werden und somit zum Aufbau einer dichten Schicht führen. Es kommen dabei Leistungen von z.B 40kW und mehr zum Einsatz. Allerdings ist es nur im Rahmen eines kurzen Leistungspulses möglich von der Kathode Material zu zerstäuben, da diese bei längerer Leistungseinwirkung durch Überhitzung Schaden nehmen kann. Die Dauer während der von einer Kathode mit hoher Leistung zerstäubt werden kann muss somit begrenzt werden, was zu einer maximal zulässigen Pulsdauer führt.

Ein Ansatz, dies zu verwirklichen besteht darin, die ganze Kathode in Teilkathoden aufzuteilen und Leistung sequenziell nacheinander auf die Teilkathoden zu bringen. Mit diesem Konzept ist gemeint, dass mehrere voneinander isolierte Kathoden (hier Teilkathoden genannt) in der Beschichtungsanlage vorgesehen sind, so dass es lokal beschränkt zu einem hohen Entladungsstrom kommen kann. Eine mögliche Realisierung dieses Ansatzes ist in den Deutschen Patentanmeldungen DE102011018363 und DE102206017382 beschrieben.

Während eines auf eine Teilkathode einwirkenden Leistungspulses wird von dieser Kathode mit hoher Entladungsstromdichte zerstäubt. Gleichzeitig kann oder können der oder die anderen Teilkathoden abkühlen bevor erneut ein Leistungspuls auf sie einwirkt.

Die Erfinder haben allerdings festgestellt, dass die Pulsdauer selbst einen hohen Einfluss auf die Schichteigenschaften der mittels Magnetronzerstäuben aufgebauten Schicht hat. Es werden daher Generatoren benötigt welche in der Lage sind, sowohl sehr kurze als auch relativ lange andauernde hohe Leistungspulse abzugeben..

Generatoren liefern in der Regel zuverlässig eine konstante Spannung bei konstantem Strom. Im Englischen werden sie "power supply" genannt, was übersetzt so viel wie Leistungsversorgung bedeutet. Anspruchsvoll wird die Situation, wenn es wie oben beschrieben darum geht kurze Leistungspulse hoher Leistung zu erzeugen. Beim Anschalten der Leistungsversorgung welche ein Leistung von z.B. 40kW abgeben soll vergehen bis zur vollständigen Leistungsabgabe mit den handelsüblichen Spannungsquellen grössenordnungsmässig ca. 700μs. Werden, wie vorliegend, Leistungspulse mit kürzerer Pulsdauer benötigt, so ist die zur Verfügung stehende Zeit bereits vor dem vollständigen Leistungsausbau abgelaufen. Das Leistungsprofil solcher Pulse ist entsprechend unkontrolliert dynamisch und das darauf aufbauende Zerstäubungsverfahren führt zu schlecht reproduzierbaren und in ihren Eigenschaften suboptimalen Schichten.

Mit dem vorliegenden erfindungsgemässen Verfahren soll daher eine Möglichkeit angegeben werden, in einfacher Weise zu Leistungspulsen mit definiertem Profil zu gelangen wobei die Dauer der Leistungspulse in einfacher Weise über weite Intervalle skalierbar sein sollte.

Erfindungsgemäss wird die Aufgabe dadurch gelöst, dass die einer ersten Teilkathode zugeordneten Leistungspulsintervalle mit den einer zweiten Teilkathode zugeordneten Leistungspulsintervalle geringfügig zeitlich überlappen dergestalt, dass beim Umleiten der Leistung von der ersten Teilkathode auf die zweite Teilkathode der die Leistung liefernde Generator nicht ausgeschaltet werden muss sondern die Leistungsentnahme vom Generator ununterbrochen stattfindet und es somit nicht zu einem erneuten Leistungsaufbau kommen muss. Während der Zeit der Überlappung der beiden Leistungspulsintervalle brennt das Plasma lediglich bei der ersten Teilkathode da die diesbezügliche Impedanz gegenüber der Impedanz der noch nicht gezündeten zweiten Teilkathode deutlich niedriger ist. Erst wenn am Ende des ersten Leistungspulsintervall die erste Teilkathode vom Generator getrennt wird zündet das Plasma an der zweiten Teilkathode, dies jedoch so schnell, dass es zu einer im Wesentlichen kontinuierlichen Leistungsentnahme vom Generator kommt. Liegt eine dritte Teilkathode vor, so wird dafür gesorgt, dass das der dritten Teilkathode zugeordnete Leistungspulsintervall mit dem der zweiten Teilkathode zugeordneten Leistungspulsintervall (vorzugsweise geringfügig) überlappt, so dass wiederum beim Umleiten der Leistung von der zweiten Teilkathode auf die dritte Teilkathode nicht zu einen Unterbruch der Leistungsentnahme kommt. Mit geringfügiger Überlappung ist vorliegend eine Überlappung im Bereich von x*0.01ms gemeint, wobei 0.5<x<10 ist. Allgemein ausgedrückt wird dafür gesorgt dass das der nten Teilkathode zugeordnete Leistungspulsintervall mit dem der (n-1)ten Teilkathode zugeordneten Leistungspulsintervall (vorzugsweise geringfügig) überlappt, wodurch beim Umleiten der Leistung von der (n-1)ten Teilkathode auf die nte Teilkathode ein Unterbruch der Leistungsentnahme vom Generator vermieden wird. Erst wenn die Leistung auf die letzte Teilkathode umgeleitet wurde und der dieser letzten Teilkathode zugeordnete Leistungspuls abgegeben wurde, d.h. wenn ein Leistungspulszyklus - im Folgenden auch Gruppe genannt - vollendet ist, wird die Leistungsentnahme vom Generator unterbrochen. Die sich anschliessende Leistungspause wird dazu genutzt die Teilkathoden abzukühlen, bevor erneut die erste Teilkathode mit dem ihr zugeordnetem Leistungspuls im entsprechenden Intervall beaufschlagt wird.

Ein solches Vorgehen führt allerdings dazu, dass zumindest der an der ersten Teilkathode abgegebene Leistungspuls im zeitlichen Bereich des Leistungsaufbaus des Generators liegt und der entsprechende Leistungspuls ein dementsprechend unerwünschtes Profil aufweist. Gemäss einer bevorzugten Ausführungsform der vorliegenden Erfindung wird daher vorgängig zur Beaufschlagung der ersten Teilkathode mit Leistung für zumindest näherungsweise das Leistungsaufbauintervall eine sogenannte Dummy-Kathode mit Leistung beaufschlagt. Dabei handelt es sich im Wesentlichen um einen Leistungsabsorber und nicht um eine für die Anwendung verwendete Kathode. Es wird dann dafür gesorgt, dass das der ersten Teilkathode zugeordnete Leistungspulsintervall geringfügig mit dem Leistungsaufbauintervall überlappt, wodurch beim Umleiten von der Dummy-Kathode auf die erste Teilkathode ein Unterbruch der Leistungsentnahme vom Generator vermieden wird und im Rahmen des ersten Leistungspulsintervalls im Wesentlichen bereits die volle Leistung zur Verfügung steht. Die oben erwähnte Dummy-Kathode kann beispielsweise mit einem Stromkreis mit ohmschem Widerstand verwirklicht werden, an dem die entsprechende Spannung abfällt und die Leistung somit in Wärme umgesetzt wird.

Wie zuvor erwähnt kann das Leistungsaufbauintervall durchaus in der Grössenordnung um die $700\mu s$ liegen. Die während dieses Intervalls vom Generator an die Dummy-Kathode abgegebene Leistung kommt dem Beschichtungsprozess nicht zugute, geht also verloren und stellt einen Verlust dar. Dies ist dann unproblematisch wenn der Leistungspulszyklus, also das Gruppenintervall gross gegenüber dem Leistungsaufbauintervall ist und somit der Leistungsverlust lediglich einen kleinen Prozentsatz ausmacht. Dies ist allerdings problematisch, wenn die Leistungsimpulsintervalle so klein werden, dass das Leistungsaufbauintervall im Vergleich zum Gruppenintervall durchaus relevant wird. In einem solchen Fall kommt es zu einem signifikanten und damit inakzeptablen Leistungsverlust.

Dies kann mit einer weiteren bevorzugten Ausführungsform der vorliegenden Erfindung vermieden werden. Die Erfinder haben nämlich erkannt, dass gerade bei kurzen Leistungspulsintervallen ein Abkühlen der Teilkathoden noch gar nicht notwendig ist. In diesem Fall wird an den ersten Leistungspulszyklus ein zweiter Leistungspulszyklus angeschlossen. Dabei wird dafür gesorgt, dass das erste Leistungspulsintervall des zweiten Leistungspulszyklus (d.h. der zweiten Gruppe) geringfügig mit dem letzten Leistungspulsintervall des ersten Leistungspulszyklus der ersten Gruppe überlappt, so dass ein Umleiten der Leistung von der letzten Teilkathode auf die erste Teilkathode ohne Unterbruch der Leistungsentnahme vom Generator möglich ist. Auf diese Weise wird für die zweite Gruppe ein Leistungsaufbauintervall und der mit dem Abführen der Leistung auf die Dummy-Kathode einhergehende Leistungsverlust vermieden. Es ist möglich, auf entsprechende Weise so viele Gruppen aneinander zu reihen, bis aufgrund der bei den Teilkathoden auftretenden Wärmeentwicklung ein tatsächlicher Unterbruch der Leistungszuführung stattfinden muss oder sollte. In einem solchen Gruppenzug wird es lediglich einmal zu Anfang des Zuges notwendig sein, die Leistung während des Leistingsaufbauintervalls auf die Dummy-Kathode zu leiten.

Die Erfindung wird nun im Detail und anhand von Schemata beispielhaft anhand der Zerstäubungstechnologie (Sputtertechnologie) erläutert.

Figur 1 stellt einen solchen Gruppenzug schematisch dar

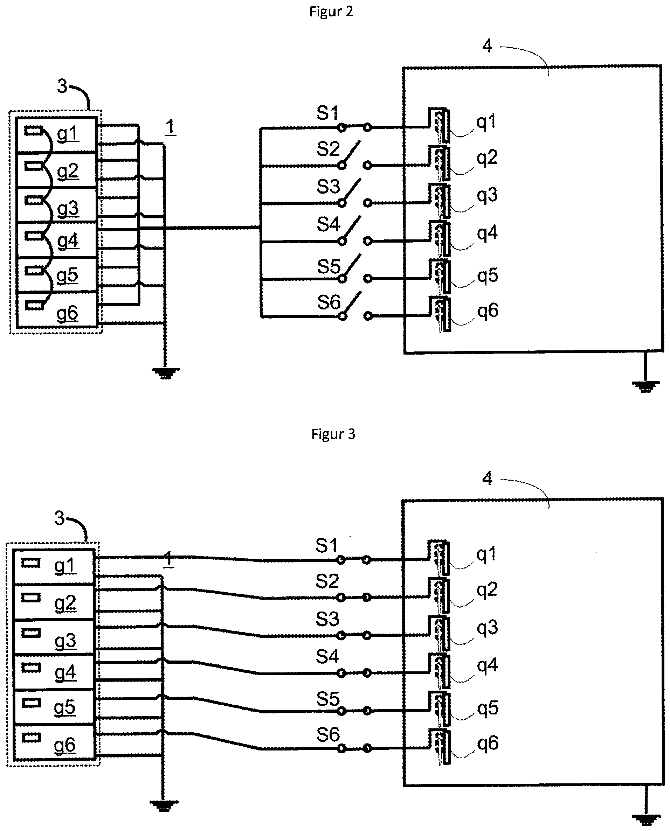

Figur 2 zeigt einen Aufbau gemäss einer Ausführungsform wonach einer Leistungsversorgungseinheit 3 Generatoren g1 bis g6 umfasst, die als Master-Slave Einheit konfiguriert sind und über die Schalter S1 bis S6 mit den Teilkathoden q1 bis q6 verbunden werden kann.

Figur 3 zeigt den Aufbau gemäss Figur 2, wobei die Master-Slave Einheit aufgelöst ist so dass jede der Teilkathoden von einem Generator direkt gespeist werden kann.

Es werden folgende Abkürzungen bei den nachfolgenden Beispielen verwendet:

| | |
|---|---|
| Pavg | mittlere Sputterleistung |
| Pmax | maximale Sputterleistung ( Pulse Power) |
| tpn | Pulslänge |
| tdn | Pulsverzögerung |
| N | Anzahl der Gruppen (N = 0 ... 500) |
| n | Kanalnummer |
| | (=Anzahl Teilkathoden, n = 0 ....6, n=0 entspricht Dummy-Kathode) |
| fr | Wiederholfrequenz |
| tr | Wiederholdauer = 1/fr |

Um eine Kathodenüberhitzung zu vermeiden wird beispielhaft angenommen dass innerhalb eines Leistungszuges die Gesamtzeit während der auf eine Teilkathode Leistung aufgebracht werden kleiner als 100ms sein muss:

$$(tpn-tdn)*N < 100ms = Tmax$$

1. Beispiel

Im Rahmen des ersten Beispiels wird die Dummy-Kathode für 0.5ms mit Leistung beaufschlagt, d.h. das Verlustintervall tp0 beträgt 0.5ms und umfasst damit sicherlich das Leistungsaufbauintervall von ca. 0.25ms. Zusätzlich zur Dummy-Kathode werden 6 Teilkathoden verwendet. Die Leistungspulsintervalle während der in einer Gruppe Leistung auf eine Teilkathode aufgebracht wird, werden auf tp1-6 = 0.2ms festgelegt und der

Überlapp der Leistungspulsintervalle wird auf td1-6 = 0.02ms festgelegt. Es werden insgesamt 10 Leistungspulszyklen gefahren, d.h. 10 Gruppen bilden zusammen mit dem Verlustintervall einen Zug. Damit dauert die Gesamtzugintervall 10*6*(0.2ms-0.02ms)+0.5ms = 10.8ms+0.5ms =11.3ms.

Damit steht ein Verlustintervall von 0.5ms einer für die Beschichtungszwecke verwendeten Zeit für Leistungsabgabe von 10.8ms gegenüber. Im Vergleich zu dem Leistungsverlust an der Dummy-Kathode wird also mehr als 20 mal soviel Leistung für Beschichtungszwecke einesetzt.

Liegen nun während des Leistungspulsintervalls 40kW an einer Teilkathode und ist eine mittlere Sputterleistung von 5kW an jeder Teilkathode vorgegeben, so sollte das Gesamtzugintervall mit einer Frequenz von 69.4Hz wiederholt werden, weil gilt:

$$(tpn-tdn)*N*Pmax*fr=0.18ms*10*40kW*69.4Hz = 5kW.$$

Dem steht an der Dummy-Kathode ein mittlerer Leistungsverlust von maximal 0.5ms*40kW*69.4Hz=1.39kW gegenüber. Eine Wiederholfrequenz von 69.4Hz entspricht einer Wiederholdauer von 14.4ms. Bei einer Dauer des Gesamtzugintervalls von 11.3ms bedeutet dies, dass zwischen den Zügen eine Pause von 3.1ms eingelegt werden sollte.

2. Beispiel

Im Rahmen des zweiten Beispiels wird das Leistungspulsintervall auf 0.07ms reduziert und die Anzahl der Gruppen auf 100 erhöht. Die anderen Parameter werden beibehalten. Damit dauert das Gesamtzugintervall 100*6*(0.07ms-0.02ms)+0.5ms=30ms+0.5ms=30.5ms.

Damit steht ein Verlustintervall von 0.5ms einer für die Beschichtungszwecke verwendeten Zeit für Leistungsabgabe von 30ms gegenüber. Im Vergleich zu dem Leistungsverlust an der Dummy-Kathode wird also mehr als 60 mal soviel Leistung für Beschichtungszwecke eingesetzt.

Liegen nun während des Leistungspulsintervalls 40kW an einer Teilkathode und ist eine mittlere Sputterleistung von 5kW an jeder Teilkathode vorgegeben, so sollte Gesamtzugintervall mit einer Frequenz von 25Hz wiederholt werden, weil gilt:

$$(tpn-tdn)*N*Pmax*fr=0.05ms*100*40kW*25Hz = 5kW$$

Dem steht ein mittlerer Leistungsverlust an der Dummy-Kathode von maximal 0.5ms*40kW*25Hz=0.5kW gegenüber. Die Wiederholfrequenz von 25Hz entspricht einer Wiederholdauer von 40ms. Bei einer Dauer des Gesamtzugintervalls von 30.5ms bedeutet dies, dass eine Pause von 9.5ms zwischen zwei Zügen eingelegt werden sollte.

3. Beispiel

Im Rahmen des dritten Beispiels wird das Leistungspulsintervall auf 0.05ms reduziert und die Anzahl der Gruppen auf 1000 erhöht. Die anderen Parameter werden beibehalten. Damit dauert das Gesamtzugintervall 1000*6*(0.05ms-0.02ms)+0.5ms=180ms+0.5ms=180.5ms.

Dait steht ein Verlustintervall von 0.5ms einer für die Beschichtungszwecke verwendeten Zeit für Leistungsabgabe von 180ms gegenüber. Im Vergleich zu dem Leistungsverlust an der Dummy-Kathode wird also mehr als 360 mal so viel Leistung für Beschichtungszwecke eingesetzt.

Liegen nun während des Leistungspulsintervalls 60kW an einer Teilkathode und ist eine mittlere Sputterleistung von ca. 5kW an jeder Teilkathode vorgegeben, so sollte das Gesamtzugintervall mit einer Frequenz von 2.7Hz wiederholt

werden, weil gilt:

$$(tpn-tdn)*N*Pmax*fr=0.03ms*1000*60kW*2.7Hz = 4.86kW$$

Dem steht ein mittlerer Leistungsverlust an der Dummy-Kathode von maximal 0.5ms*60kW*2.7Hz=81W gegenüber. Die Wiederholfrequenz von 2.7Hz entspricht einer Wiederholdauer von 360ms. Bei einer Dauer des Gesamtzugintervalls von 180.5ms bedeutet dies, dass eine Pause von 179.5ms zwischen zwei Zügen eingelegt werden sollte.

4. Beispiel

Im Rahmen des vierten Beispiels wird das Leistungspulsintervall mit 0.05ms und die Anzahl der Gruppen mit 1000 beibehalten, ebenso die anderen Parameter. Damit dauert das Gesamtzugintervall 1000*6*(0.05ms-0.02ms)+0.5ms=180ms+0.5ms=180.5ms.

Damit steht ein Verlustintervall von 0.5ms einer für die Beschichtungszwecke verwendeten Zeit für Leistungsabgabe von 180ms gegenüber. Im Vergleich zu dem Leistungsverlust an der Dummy-Kathode wird also mehr als 360 mal soviel Leistung für Beschichtungszwecke eingesetzt.

Liegen nun während des Leistungspulsintervalls nicht mehr 60kW wie im Beispiel 3, sondern lediglich 33kW an einer Teilkathode und ist eine mittlere Sputterleistung von ca. 5kW an jeder Teilkathode vorgegeben, so sollte das Gesamtzugintervall mit einer Frequenz von 5.05Hz wiederholt werden, weil gilt:

$$(tpn-tdn)*N$$

$$*Pmax*fr=0.03ms*1000*33kW*5.05Hz = 5kW$$

Dem steht ein mittlerer Leistungsverlust an der Dummy-Kathode von maximal 0.5ms*33kW*5.05Hz=83W gegenüber. Die Wiederholfrequenz von 5.05Hz entspricht einer Wiederholdauer von 198ms. Bei einer Dauer des Gesamtzugintervalls von 180.5ms bedeutet dies, dass eine Pause von lediglich 17.5ms zwischen zwei Zügen eingelegt werden sollte.

Wie die oben skizzierten Beispiele zeigen erlaubt das erfindungsgemässe Verfahren eine einfache Skalierung der Pulsdauer, Pulshöhe, Pulswiederholfrequenz sowie der genauen Definition des Pulsprofiles bei einer nahezu verschwindend geringen Verlustleistung. All diese Grössen, die unter dem Stichwort skalierbare Pulscharakteristik zusammengefasst werden können, haben beim Sputtern und insbesondere im Rahmen der HIPIMS-Techologie direkten Einfluss auf die Eigenschaften der dabei entstehenden Schichten. Obwohl die Beschreibung die Erfindung die Bereitstellung von Leistungspulsen im Rahmen der Sputtertechnologie darstellt ist sie überall dort vorteilhaft anwendbar, wo eine vergleichsweise hohe Leistung im Rahmen von Pulsen auf eine Last aufgebracht werden muss.

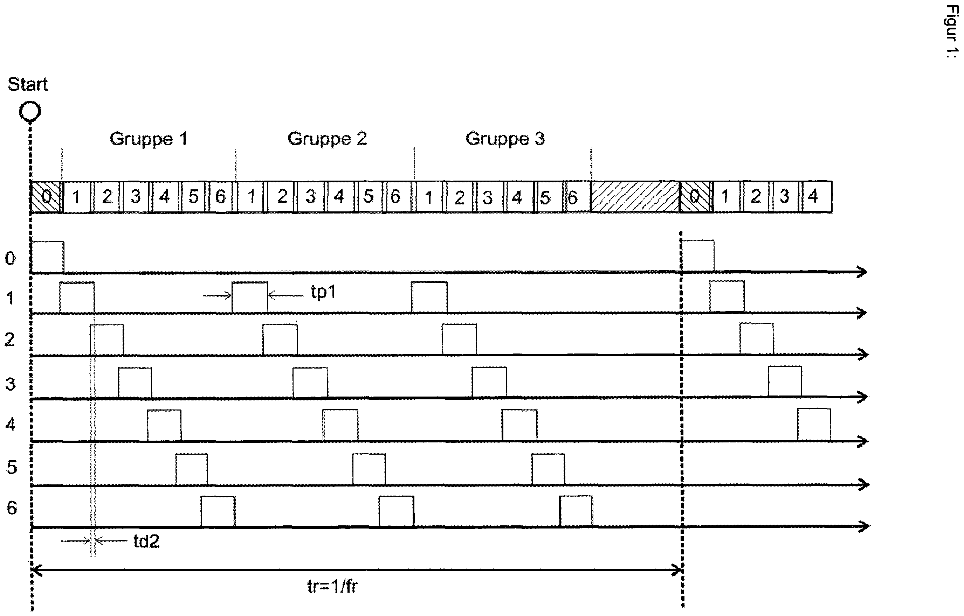

Die Figur 1 zeigt die den Beispielen entsprechende Situation sowohl als einheitlicher Zug als auch aufgesplittet in das Verlustintervall (0) und die Leistungspulsintervalle an den Teilkathoden (1-6). Dabei stellt die horizontale Achse die Zeitachse dar und die Vertikale Achse entspricht der vom Generator abgegebenen Leistung. Allerdings sind in der Figur lediglich 3 Gruppen gezeigt.

Wie oben beschrieben wird es durch das Einführen einer Dummy-Kathode möglich, dass jede der Teilkathoden mit einem genau definiertes Leistungs-Pulsprofil beaufschlagt werden kann, da diese Dummy-Kathode die während des Leistungsaufbauintervalls abgegebene Leistung verarbeiten kann. Wie die Erfinder herausgefunden haben ist diese Dummy-Kathode aber auch dann sehr nützlich, falls es während des Sputterns zum sogenannten Arcing kommt. Wird nämlich mittels einer Detektionseinrichtung ein solches Arcing -auch Blitzen genannt - erkannt, so wird üblicherweise der Generator ausgeschaltet, was bedeutet, dass innerhalb eines Zuges nicht mehr eine ununterbrochene Leistungsabgabe durch den Generator vorliegt. Demgegenüber ist es mit Hilfe der Dummy-Kathode möglich, die Leistung auf diese Kathode umzuleiten und der Generator kann ungestört und ununterbrochen seine Leistung abgeben.

Es bleibt noch anzumerken, dass das erfindungsgemässe Verfahren der Bereitstellung sequenzieller Leistungspulse es erlaubt einfache Generatoren zu verwenden. So kann der Generator beispielsweise eine Leistungsversorgungseinheit sein welche als Master-Slave Einheit konfiguriert ist. Unter Master -Slave Konfiguration ist der parallele Zusammenschluss der Ausgänge zweier oder mehrerer Generatoren zu verstehen, wobei die einzustellende Leistung an einem der Generatoren (dem Master) gewählt wird und die anderen Generatoren elektronisch so verbunden sind, dass sie dem Master in ihren Einstellungen folgen. Dies hat insbesondere auch noch den Vorteil, dass wenn beispielsweise von HIPIMS-Sputtern auf konventionelles Sputtern umgeschaltet werden soll, die Master-Slave-Konfiguration aufgelöst werden kann und den Teilkathoden jeweils der Master oder ein Slave zugeordnet werden kann.

Vorzugsweise umfassen die Teilkathoden hinter den Targets jeweils bewegliche Magnetsysteme, welche dafür sorgen, dass der jeweilige Racetrack über das jeweilige Teiltarget wandert. Falls die Anlage im HIPIMS-Modus betrieben wird bewegen sich erfindungsgemäss die hinter den Teiltargets vorzugsweise rotierenden Magnetsysteme mit einer Frequenz, welche vorzugsweise mit der Frequenz des wiederkehrenden Leistungspulses der Sputterquelle kein rationnales Verhältnis bildet. Hierdurch ist sichergestellt ist, dass gleichmässig Material von der Targetoberfläche abgetragen wird.

Es wurde ein Verfahren beschrieben zur Bereitstellung von Leistungspulsen mit skalierbarem Leistungspulsintervall zum Betreiben einer PVD-Zerstäubungskathode die PVD-Zerstäubungskathode eine erste Teilkathode und eine zweite Teilkathode umfasst, wobei für die Teilkathoden eine maximale mittlere Leistungsbeaufschlagung vorgegeben ist und wobei die Dauer der Leistungspulsintervalle vorgegeben werden und das Verfahren folgende Schritte umfasst

> a) Bereitstellen eines Generators mit vorgegebener vorzugsweise zumindest nach Anschalten und nach Ablauf eines Leistungsaufbauintervalls konstanter Leistungsabgabe

> b) Anschalten des Generators

> c) Anschluss der ersten Teilkathode an den Generator, so dass die erste Teilkathode mit Leistung vom Generator beaufschlagt wird

> d) Trennung des Generators von der ersten Teilkathode nach Ablauf eines vorgegebenen der ersten Teilkathode entsprechenden ersten Leistungspulsintervalls

> e) Anschluss der zweiten Teilkathode an den Generator so dass die zweite Teilkathode mit Leistung vom Generator beaufschlagt wird

> f) Trennung des Generators von der zweiten Teilkathode nach Ablauf eines vorgegebenen der zweiten Teilkathode entsprechenden zweiten Leistungspulsintervalls

wobei das erste Leistungspulsintervall zeitlich vor dem zweiten Leistungspulsintervall beginnt und das erste Leistungspulsintervall zeitlich vor dem zweiten Leistungspulsintervall endet, wobei die Schritte d) und e) so ausgeführt werden dass sich erstes Leistungspulsintervall und zweites Leistungspulsintervall zeitlich überlappen und alle Leistungspulsintervalle zusammen eine erste Gruppe bilden, so dass die Leistungsabgabe vom Generator durchgehend ohne Unterbrechung vom Anfang des ersten Leistungspulsintervalls bis zum Ende des zweiten Leistungspulsintervalls bestehen bleibt und es nicht zu einem zweiten Leistungsaufbauintervall kommt.

Die zeitliche Überlappung des ersten Leistungspulsintervalls und des zweiten Leistungspulsintervalls sollten vorzugsweise nicht mehr als x% der Leistungspulsintervalle bzw. falls erstes Leistungspulsintervall sich vom zweiten Leistungspulsintervall in der Dauer unterscheidet, nicht mehr als x% des Leistungspulsintervalls kürzerer Dauer betragen, wobei x kleiner gleich 20, vorzugsweise x kleiner gleich 10 ist.

Die PVD-Zerstäubungskathode kann zumindest eine weitere Teilkathode, bevorzugt mehrerer weitere Teilkathoden umfasst, wobei die weitere Teilkathode entsprechend der Schritte e) und f) an den Generator angeschlossen und von ihm getrennt werden wobei das jeweils der an die Reihe kommenden weiteren Teilkathode zugeordneten Leistungspulsintervalle mit dem Leistungspulsintervall welches der unmittelbar zuvor an die Reihe gekommenen Teilkathode entspricht zeitlich überlappt und erstes, zweites und das oder die weiteren Leistungspulsintervalle zusammen die zeitlich ununterbrochene erste Gruppe bilden, so dass die Leistungsabgabe vom Generator während des durch die erste Gruppe gebildeten Guppenintervalls durchgehend ohne Unterbrechung bestehen bleibt und es nicht zu einem zweiten Leistungsaufbauintervall kommt.

An die erste Gruppe kann eine zweite Gruppe angehängt werden innerhalb derer der ersten Gruppe entsprechend die erste, zweite und gegebenenfalls die weiteren Teilkathoden mit Leistungspulsen innerhalb sich überlappender Leistungspulsintervallen beaufschlagt werden, wobei die zweite Gruppe so an die erste Gruppe angehäng werden kann, dass das erste Leistungspulsintervall der zweiten Gruppe mit dem letzten Leistungspulsintervall der ersten Gruppe überlappt, so dass die Leistungsabgabe vom Generator vom Anfang des ersten Leistungsintervalls der ersten Gruppe bis zum Ende des letzten Leistungsintervalls der zweiten Gruppe durchgehend ohne Unterbrechung bleibt und es nicht zu einem zweiten Leistungsaufbauintervall kommt

Entsprechend der für Gruppe 1 und 2 formulierten Bedingungen können N Gruppen aneinander angehängt werden, wobei N eine ganze Zahl >1 ist.

Die Zahl N der Gruppen sollte vorzugsweise maximal jedoch nur so gross gewählt werden, dass für jede Teilkathode n gilt, dass die Summe der ihr zugeordneten Leistungspulsintervalle tpn abzüglich jeweils einer Überlappung tdn über alle Gruppen 1 bis N eine maximale Zeit von 100ms nicht überschreitet.

Es kann während eines Verlustintervalls die vom Generator abgegebene Leistung an eine nicht für beispielsweise eine Beschichtung genutzte Last abgegeben werden, wobei das Verlustintervall das Leistungsaufbauintervall zumindest umfasst und das Verlustintervall mit dem ersten Leistungspulsintervall der ersten Gruppe überlappt und das Verlustintervall zusammen mit den Gruppen einen ununterbrochenen Zug bildet.

Das oben skizzierte Verfahren kann vielfach wiederholt werden und jeweils nach dem letzten Leistungspulsintervall der letzten Gruppe kann der Generator für eine Pause abgeschaltet werden und die Pause kann so lange gewählt werden dass die an die Teilkathoden abgegebene zeitlich gemittelte Leistung unter Berücksichtigung der Pausen einem vorgegebenen Wert entspricht.

Mit dem oben beschriebenen Verfahren kann ein HIPIMS-Verfahren durchgeführt werden, wobei die vorgegebene Leistung des Generators bei mindestens 20kW vorzugsweise bei mindestens 40kW und besonders bevorzugt bei 60kW liegt.

Bei dem HIPIMS-Verfahren können die Parameter vorzugsweise so gewählt werden dass die an die Teilkathoden abgegebene zeitlich gemittelte Leistung unter 10kW und bevorzugt bei 5kW liegt, wobei die zeitweise und lokal an den Teilkathoden herrschende Entladungsstromdichte vorzugsweise grösser als $0.2A/cm^2$ ist.

Es wurde ein Verfahren zur Bereitstellung von Leistungspulsen mit skalierbarem Leistungspulsintervall zum Betreiben einer PVD-Zerstäubungskathode offenbart, wobei die PVD-Zerstäubungskathode ein Leistungsaufnahmebauteil und eine erste Teilkathode umfasst, wobei für die Teilkathode eine maximale mittlere Leistungsbeaufschlagung vorgegeben ist und wobei die Dauer der Leistungspulsintervalle vorgegeben werden und das Verfahren folgende Schritte umfasst

a) Bereitstellen eines Generators mit vorgegebener vorzugsweise zumindest nach Anschalten und nach Ablauf eines Leistungsaufbauintervalls konstanter Leistungsabgabe

b) Anschalten des Generators

c) Anschluss des Leistungsaufnahmebauteils an den Generator, so dass das Leistungsaufnahmebauteil während des Leistungsaufbauintervalls mit der Leistung vom Generator beaufschlagt wird

d) Trennung des Generators vom Leistungsaufnahmebauteil nach Ablauf des Leistungsaufbauintervalls.

e) Anschluss der ersten Teilkathode an den Generator so dass die erste Teilkathode mit Leistung vom Generator beaufschlagt wird

f) Trennung des Generators von der ersten Teilkathode nach Ablauf eines vorgegebenen der ersten Teilkathode entsprechenden ersten Leistungspulsintervalls

Das Verfahren ist dadurch gekennzeichnet dass die Schritte d) und e) so ausgeführt werden, dass es bei Anschluss der ersten Teilkathode an den Generator nicht zu einem zweiten Leistungsaufbauintervall kommt wobei dies bevorzugt dadurch erreicht wird, dass sich Leistungsaufbauintervall und erstes Leistungspulsintervall zeitlich überlappen und die Leistungsabgabe des Generators nicht unterbrochen werden muss.

In der Beschreibung wurde häufiger das Wort "Dummy Kathode" verwendet. Diese ist nicht notwendigerweise eine wirkliche Kathode sondern ist als identisch mit dem Leistungsaufnahmebauteil zu verstehen. Charakteristisch für das Leistungsaufnahmebauteil ist, dass es nicht eingesetzt wird als Materiallieferant für zu beschichtende oder zu bearbeitende Substrate.

In der Beschreibung ist das Wort Teilkathode so zu verstehen, dass mehrere elektrisch isolierte Kathoden ein Kathodensystem bilden und diese Kathoden als Teil des Systems und somit als Teilkathoden bezeichnet werden.

Das Verfahren kann weiterhin folgende Schritte umfassen:

g) Anschluss einer zweiten Teilkathode an den Generator so dass die zweite Teilkathode mit Leistung vom Generator beaufschlagt wird

h) Trennung des Generators von der zweiten Teilkathode nach Ablauf eines vorgegebenen der zweiten Teilkathode entsprechenden ersten Leistungspulsintervalls

wobei die Schritte f) und g) so ausgeführt werden, dass die Leistungsabgabe vom Generator durchgehend ohne Unterbrechung vom Anfang des Leistungsaufbauintervalls bis zum Ende des zweiten Leistungspulsintervalls bestehen bleibt und es nicht zu einem zweiten Leistungsaufbauintervall kommt wobei dies vorzugsweise erreicht wird indem sich erstes Leistungspulsintervall und zweites Leistungspulsintervall zeitlich überlappen wobei das erste Leistungspulsintervall zeitlich vor dem zweiten Leistungspulsintervall beginnt und das erste Leistungspulsintervall zeitlich vor dem zweiten Leistungspulsintervall endet.

Es können n weitere Teilkathoden entsprechend den Schritten f), g) und h) der Reihe nach nacheinander an den Generator angeschlossen und von diesem abgeschaltet werden, wobei vorzugsweise das n-1ste Leistungspulsintervall mit dem nten Leistungspulsintervall zeitlich überlappt.

Es können Mittel zur Detektion von Arcing vorgesehen sein und bei der Detektion eines Arcs das Leistungsaufnahmebauteil an den Generator angeschlossen wird und die aktuell angeschlossene Teilkathode vom Generator getrennt wird derart, dass die Leistungsabgabe vom Generator nicht unterbrochen wird.

Unter Arcing wird in der vorliegenden Beschreibung meist der elektrische Durchbruch verstanden welcher zu einem plötzlichen Zusammenbruch der Spannung und/oder Anstieg des Stromes führt.

**Patentansprüche**

1. Verfahren zur Bereitstellung von Leistungspulsen mit skalierbarem Leistungspulsintervall zum Betreiben einer PVD-Zerstäubungskathode wobei die PVD-Zerstäubungskathode ein Leistungsaufnahmebauteil und zumindest eine erste Kathode oder eine erste Teilkathode umfasst, wobei für die Kathode oder Teilkathode eine maximale mittlere Leistungsbeaufschlagung vorgegeben ist und wobei die Dauer der Leistungspulsintervalle vorgegeben werden und das Verfahren folgende Schritte umfasst:

   a) Bereitstellen eines Generators mit vorgegebener vorzugsweise zumindest nach Anschalten und nach Ablauf eines Leistungsaufbauintervalls konstanter Leistungsabgabe,
   b) Anschalten des Generators,
   c) Anschluss des Leistungsaufnahmebauteils an den Generator, so dass das Leistungsaufnahmebauteil während des Leistungsaufbauintervalls mit der Leistung vom Generator beaufschlagt wird,
   d) Trennung des Generators vom Leistungsaufnahmebauteil nach Ablauf des Leistungsaufbauintervalls,
   e) Anschluss der ersten Kathode oder Teilkathode an den Generator so dass die erste Kathode oder Teilkathode mit Leistung vom Generator beaufschlagt wird,
   f) Trennung des Generators von der ersten Kathode oder Teilkathode nach Ablauf eines vorgegebenen der ersten Kathode oder Teilkathode entsprechenden ersten Leistungspulsintervalls,

   **dadurch gekennzeichnet dass** das Leitungsaufnahmebauteil nicht als Materiallieferant für zu beschichtende oder zu bearbeitende Substrate eingesetzt wird und die Schritte d) und e) so ausgeführt werden, dass es bei Anschluss der ersten Kathode oder Teilkathode an den Generator nicht zu einem zweiten Leistungsaufbauintervall kommt und die Leistungsabgabe des Generators nicht unterbrochen werden muss.

2. Verfahren nach Anspruch 1, **dadurch gekennzeichnet, dass** sich Leistungsaufbauintervall und erstes Leistungspulsintervall zeitlich überlappen und dadurch es nicht zu einem zweiten Leistungsaufbauintervall kommt.

3. Verfahren nach einem der vorangehenden Ansprüche, **dadurch gekennzeichnet dass** die PVD-Zerstäubungskathode zumindest eine erste und eine zweite Teilkathode umfasst und das Verfahren weiterhin folgende Schritte umfasst:

   g) Anschluss der zweiten Teilkathode an den Generator so dass die zweite Teilkathode mit Leistung vom Generator beaufschlagt wird,
   h) Trennung des Generators von der zweiten Teilkathode nach Ablauf eines vorgegebenen der zweiten Teilkathode entsprechenden ersten Leistungspulsintervalls,

   wobei die Schritte f) und g) so ausgeführt werden, dass die Leistungsabgabe vom Generator durchgehend ohne Unterbrechung vom Anfang des Leistungsaufbauintervalls bis zum Ende des zweiten Leistungspulsintervalls bestehen bleibt und es nicht zu einem zweiten Leistungsaufbauintervall kommt.

4. Verfahren nach Anspruch 3, **dadurch gekennzeichnet dass** sich erstes Leistungspulsintervall und zweites Leistungspulsintervall zeitlich überlappen wobei das erste Leistungspulsintervall zeitlich vor dem zweiten Leistungspulsintervall beginnt und das erste Leistungspulsintervall zeitlich vor dem zweiten Leistungspulsintervall endet und dadurch es nicht zu einem zweiten Leistungsaufbauintervall kommt.

**5.** Verfahren nach einem der vorangehenden Ansprüche 3 bis 4, **dadurch gekennzeichnet, dass** n weitere Teilkathoden entsprechend den Schritten f), g) und h) der Reihe nach nacheinander an den Generator angeschlossen und von diesem abgeschaltet werden, wobei vorzugsweise das n-1ste Leistungspulsintervall mit dem nten Leistungspulsintervall zeitlich überlappt.

**6.** Verfahren nach einem der vorangehenden Anspruche, **dadurch gekennzeichnet, dass** Mittel zur Detektion von Arcing vorgesehen sind und bei der Detektion eines Arcs das Leistungsaufnahmebauteil an den Generator angeschlossen wird und die aktuell angeschlossene Kathode oder Teilkathode vom Generator getrennt wird derart, dass die Leistungsabgabe vom Generator nicht unterbrochen wird.

**Claims**

**1.** Method for supplying power pulses with a scalable power pulse interval for operating a PVD sputtering cathode, wherein the PVD sputtering cathode comprises a power consumption component and at least a first cathode or a first partial cathode, wherein for the cathode or the partial cathode a maximum average power feed is prescribed and wherein the duration of the power pulse intervals is prescribed, and the method comprises the following steps:

a) providing a generator with a predefined power output, preferably a power output that is constant at least after switching on and after expiration of a power buildup interval,
b) switching on the generator,
c) connecting the power consumption component to the generator so that power from the generator is applied to the power consumption component during the power buildup interval,
d) disconnecting the generator from the power consumption component after expiration of the power buildup interval,
e) connecting the first cathode or partial cathode to the generator so that power from the generator is applied to the first cathode or partial cathode,
f) disconnecting the generator from the first cathode or partial cathode after expiration of a predefined first power pulse interval corresponding to the first cathode or partial cathode,

**characterized in that** the power consumption component is not used as material supplier for substrates to be coated or to be treated and the steps d) and e) are executed in such a manner that, when the first cathode or partial cathode is connected to the generator, there is no second power buildup interval and the power output of the generator does not need to be interrupted.

**2.** Method according to claim 1, **characterized in that** the power buildup interval and the first power pulse interval overlap time-wise and thus there is no second power buildup interval.

**3.** Method according to one of the preceding claims, **characterized in that** the PVD sputtering cathode comprises at least a first and a second partial cathode and the method furthermore comprises the following steps:

g) connecting the second partial cathode to the generator so that power from the generator is applied to the second partial cathode,
h) disconnecting the generator from the second partial cathode after expiration of a predefined first power pulse interval corresponding to the second partial cathode,

wherein the steps f) and g) are executed in such a manner that the power output from the generator persists continuously without interruption from the beginning of the power buildup interval to the end of the second power pulse interval and there is no second power buildup interval.

**4.** Method according to claim 3, **characterized in that** the first power pulse interval and the second power pulse interval overlap time-wise, wherein the first power pulse interval starts temporally before the second power pulse interval and the first power pulse interval ends temporally before the second power pulse interval and thus there is no second power buildup interval.

**5.** Method according to one of the preceding claims 3 to 4, **characterized in that** n further partial cathodes are connected sequentially in turn to the generator and disconnected from the latter in accordance with steps f), g) and h), wherein preferably the n-1$^{th}$ power pulse interval overlaps time-wise with the n$^{th}$ power pulse interval.

6. Method according to one of the preceding claims, **characterized in that** means for detecting arcing are provided and, in the event of an arc being detected, the power consumption component is connected to the generator and the currently connected cathode or partial cathode is disconnected from the generator in such a way that the power output from the generator is not interrupted.

**Revendications**

1. Procédé pour fournir des impulsions de puissance avec un intervalle d'impulsion de puissance évolutif pour actionner une cathode de pulvérisation PVD, la cathode de pulvérisation PVD comprenant un composant absorbant la puissance et du moins une première cathode ou une première cathode partielle, une alimentation de puissance moyenne maximale étant prédéfini pour la cathode ou la cathode partielle et la durée des intervalles d'impulsions de puissance étant prédéfinie et le procédé comprenant les étapes suivantes :

   a) fournir un générateur ayant une puissance utile prédéfinie, de préférence une puissance utile qui est constante du moins après l'allumage et après l'expiration d'un intervalle de développement de puissance,
   b) allumer le générateur,
   c) brancher le composant absorbant la puissance au générateur de sorte que le composant absorbant la puissance est alimenté en puissance du générateur pendant l'intervalle de développement de puissance,
   d) séparer le générateur du composant absorbant la puissance après l'expiration de l'intervalle de développement de puissance,
   e) brancher la première cathode ou cathode partielle au générateur de sorte que la première cathode ou cathode partielle est alimentée en puissance du générateur,
   f) séparer le générateur de la première cathode ou cathode partielle après l'expiration d'un premier intervalle d'impulsion de puissance prédéfini qui correspond à la première cathode ou cathode partielle,

   **caractérisé en ce que** le composant absorbant la puissance n'est pas utilisé comme fournisseur de matériau pour des substrats à revêtir ou à traiter et les étapes d) et e) sont effectuées de telle manière que, lorsque la première cathode ou cathode partielle est branchée au générateur,
   il n'y a pas de second intervalle de développement de puissance et il n'est pas nécessaire d'interrompre la puissance utile du générateur.

2. Procédé selon la revendication 1 **caractérisé en ce que** l'intervalle de développement de puissance et le premier intervalle d'impulsion de puissance se chevauchent temporellement et ainsi il n'y a pas de second intervalle de développement de puissance.

3. Procédé selon l'une des revendications précédentes **caractérisé en ce que** la cathode de pulvérisation PVD comprend du moins une première et une seconde cathode partielle et le procédé comprend en outre les étapes suivantes :

   g) brancher la seconde cathode partielle au générateur de sorte que la seconde cathode partielle est alimenté en puissance du générateur,
   h) séparer le générateur de la seconde cathode partielle après l'expiration d'un premier intervalle d'impulsion de puissance prédéfini qui correspond à la seconde cathode partielle,

   les étapes f) et g) étant effectuées de telle manière que la puissance utile du générateur persiste en continue sans interruption dès le début de l'intervalle de développement de puissance jusqu'à la fin du second intervalle d'impulsion de puissance et il n'y a pas de second intervalle de développement de puissance.

4. Procédé selon la revendication 3 **caractérisé en ce que** le premier intervalle d'impulsion de puissance et le second intervalle d'impulsion de puissance se chevauchent temporellement, le premier intervalle d'impulsion de puissance commençant temporellement avant le second intervalle d'impulsion de puissance et le premier intervalle d'impulsion de puissance terminant temporellement avant le second intervalle d'impulsion de puissance et ainsi il n'y a pas de second intervalle de développement de puissance.

5. Procédé selon l'une des revendications précédentes 3 à 4, **caractérisé en ce que** n d'autres cathodes partielles sont branchées au générateur séquentiellement l'une après l'autre et séparées de celui-ci conformément aux étapes f), g) et h), de préférence le n-1er intervalle d'impulsion de puissance se chevauchant temporellement avec le nème intervalle d'impulsion de puissance.

6. Procédé selon l'une des revendications précédentes **caractérisé en ce que** des moyens sont prévus pour détecter arcing et en cas de détection d'un arc le composant absorbant la puissance est branché au générateur et la cathode ou cathode partielle qui est actuellement branchée est séparée du générateur de telle manière que la puissance utile du générateur n'est pas interrompue.

Figur 1:

Start

Gruppe 1   Gruppe 2   Gruppe 3

0 1 2 3 4 5 6 1 2 3 4 5 6 1 2 3 4 5 6 0 1 2 3 4

0
1
2
3
4
5
6

tp1

td2

tr=1/fr

Figur 2

Figur 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102011018363
- DE 102206017382